# EUROPEAN PATENT SPECIFICATION

(11) **EP 2 156 127 B1**
(45) Date of publication and mention of the grant of the patent: **26.06.2013**
(21) Application number: 08738178.6
(22) Date of filing: 06.04.2008
(51) Int. Cl.: H05K 7/20

(54) **AN INTEGRATED ACTIVE COOLED CABINET/RACK FOR ELECTRONIC EQUIPMENTS**
INTEGRIERTER/INTEGRIERTES AKTIV GEKÜHLTER/GEKÜHLTES SCHRANK/GESTELL FÜR ELEKTRONISCHE EINRICHTUNGEN
SUPPORT ACTIF/ARMOIRE ACTIVE INTÉGRÉS À REFROIDISSEMENT DESTINÉS À DES ÉQUIPEMENTS ÉLECTRONIQUES

(30) Priority: 05.04.2007 US 910216 P
(43) Date of publication of application: 24.02.2010
(73) Proprietor: Gigushinsky, Yekutiel, Herzliya (IL)
(72) Inventor: Gigushinsky, Yekutiel, Herzliya (IL)
(74) Representative: Modiano, Micaela Nadia
(86) International application number: PCT/IL2008/000474
(87) International publication number: WO 2008/122977

(56) References cited:
- DE-A1- 10 121 759
- US-A- 3 913 263
- US-A1- 2004 257 766
- US-A1- 2005 153 649
- US-B2- 7 112 131

## Description

### FIELD OF THE INVENTION

The present invention related in general to electronic equipment cabinets and more particularly, the invention relates to an integrated, active cooling cabinet/rack designed for housing electronic equipment. The cabinet is capable of adjusting to the cooling requirements of one or more individual electronic items housed in the cabinet.

### BACKGROUND OF THE INVENTION

Electronic equipment cabinets are intended to house various types of communications and/or computerized equipment, including active electronic and optical systems and passive mechanical cross-connect and splicing fields. The cabinets are required to protect the electronics equipment from a wide range of temperatures, to cool the heated electronic equipment /computers in the cabinet enclosure, and to remove the heat from the equipment/computers.

Prior art electronic equipment cabinets are cooled down in several methods, whereas in all prior art methods the cabinet is cooled as a whole, disregarding the amount of air and cooling required by each one and type of the hosted equipment and without ensuring and controlling the required cooling of any individual electronic equipment housed in the cabinet. It should be noted that cooling a cabinet as a whole, does not provide the required amount of air and cooling to each of the individual electronic units installed in the cabinets - which results in over heating of the electronic equipment, even when the all cabinet/room is cooled. In one common method, electronic equipment cabinets are kept in designated rooms, where the whole room is cooled down. This method often causes people working in the designated room to be very cold while the electronic equipments housed in the cabinets are still overheating. In existing computer centers, the amount of air supplied by the air conditioning units is much bigger than the amount of air which circulates inside the cabinets. Only a portion of the air is flowing through the cabinets and most of it is circulating and cooling the room. Typically, in order to supply X CFM (Cubic Feet per Minute) of air into a cabinet, 3X CFM of air has to be supplied to the room/raised floor by the air conditioning units, without being able to ensure that each one of the cabinets or individual electronic equipment inside the cabinets gets the right amount of air and temperature. as a result, the air conditioning units supplying cooled air, 3 times more than the amount required by the electronic equipment

In another method, cold air is supplied from the bottom of the cabinets, but without any possibility to control and ensure that the right amount of cooling air is supplied to each unit of electronic equipment housed in the cabinet, as required. In other prior art cabinets, heat exchanger that cools the air is installed in or adjacent to the cabinet and cooled air is supplied at the bottom or the top of the cabinet to cool the cabinet as a whole without the ability to control and ensure that each individual electronic equipment receives the required amount cooling. A system that includes a heat exchanger must be connected to chilled water piping, reduce the usable height of the cabinets and prevents a free and open access to the electronic equipment and cabling.

Typically, electronic equipments have frontal suction inlets whereas the hot air flows out from the back of the electronic equipments.

The electronic equipment/computers housed in the cabinet generate large amounts of heat that must be removed to avoid equipment failure. Furthermore, each electronic item often generates a different amount of heat from other items and thus its cooling requirement is also different from that required by other items.

There is therefore a need for and it would be advantageous to have electronic equipment cabinet that enable individual equipment monitoring and control and thereby ensure that the equipment housed in the cabinet and generating the highest level of heat is cooled down to an acceptable preset temperature.

The term "diffuser", as used herein refers to a means for deflecting air from an outlet, whereas the outlet can be an opening in a sleeve in which the air is flowing.

US 2005/153649 A1 discloses a cabinet for housing computer devices with an internal air distribution system, including an internal chamber defined by a side wall arrangement having at least a front wall, a support structure for computer devices, wherein the support structure is positioned within the internal chamber of the cabinet. The air distribution device comprises an elongated duct defining a passageway for air distribution. The duct is positioned within the internal chamber and has a plurality of adjustable air discharge ports that are in fluid communication with the passageway. The air distribution device further includes an inlet fan in fluid communication with the passageway. By precisely directing cool air to a frontal portion of the computer devices, the air distribution device reduces the temperature gradients within the cabinet and the quantity of heat that accumulates in the cabinet during operation of the computer devices.

US 2004/257766 A1 discloses a cabinet for housing electronic equipment. The cabinet is constructed and arranged to support cooling airflow in a front-to-back configuration through the cabinet and in a side-to-side configuration from one side to an opposite side of the cabinet. The cabinet can thereby provide within a single cabinet means cooling air for components using front-to-back airflow for cooling, such as information technology (IT) equipment, and for components using side-to-side airflow, such as certain types of telecommunications equipment. The cabinet can thereby support a mix of IT and telecommunications equipment, providing flexibility and adaptability in network room and data center configuration. The cabinet is further configured to separate intake air used by equipment for cooling from exhaust air vented by equipment into its interior during operation.

### SUMMARY OF THE INVENTION

The principle intention of the present invention includes providing a cabinet for housing one or more electronic equipments placed on racks, aving a front side, a back side and, two sided sides and a top side according to claim 1.

The cool air supply unit is operatively connected to an external source of cool air, whereas the air propelling device compresses cool air from the external source of cool air into the hollow posts. The external source of cool air is selected from the group of sources including: air conditioned raised floor and a canal connected to an air condition unit. The compressed cool air flows from inside the hollow posts, through the diffusers towards each of the electronic equipments placed on the cabinet racks, thereby cooling each of the electronic equipments. It should be noted that the typically, electronic equipments have air suction inlets in front of the devices and the hot air is exhausted from the back of the devices. It should be further noted that the front side, back side, two sided sides and top side can be closed or open, without interfering with the operation and cooling of the cabinet.

Preferably, the cabinet further includes a control unit for controlling the flow of air to each of the electronic equipments installed in the cabinet, thereby ensuring that each of the electronic equipments operates within the recommended range of operational temperature. The control unit includes multiple temperature sensors and a processing unit. At least one sensor is disposed at the back of each of the racks for sensing the temperature of the air coming out of each of the electronic equipments. The processing unit processes the collected temperature data and determines the maximal temperature coming out of the electronic equipments installed in the cabinet. Based on the maximal temperature, the control unit determines if the air propelling device should increase the compression of the cool air into the hollow posts.

The present invention also relates to a method for reducing the operational temperature of each one of the electronic equipments placed on racks inside a cabinet, according to claim 11.

Another aspect of the present invention is to provide a method for controlling the operational temperature of each one of the electronic equipments placed on racks inside the cabinet. The method includes providing a control unit, having a processing unit, and capable of collecting temperature data from the air outlet of each the electronic equipment installed in the cabinet, using temperature sensors. The processing unit processes the temperature data and determines the maximal temperature coming out of the electronic equipments. Based on the maximal temperature, the control unit determines if the air propelling device should increase the compression of the cool air into the hollow posts.

Preferably, the method further comprising the steps of providing a sensor for sensing the temperature of the cool air supplied by the cool air supply unit, thereby determining the incoming air temperature; and processing the incoming temperature to determine the exact air capacity needed to maintain the required operating temperature of electronic equipments installed in the cabinet. It should be noted that by monitoring both the incoming temperature (*T1*) and the maximal temperature *(T2ₘₐₓ),* the control unit can automatically adjust the exact air capacity needed to maintain the required operating temperature of each electronic. The control unit computed *ΔT = T2ₘₐₓ - T1* to determine the cooling air load that is needed to maintain an appropriate *T2ₘₐₓ.* That is, if either *T2ₘₐₓ* or *T1* increase, more cooling air load is needed, and if either *T2ₘₐₓ* or *T1* decrease, less cooling air load is needed.

It should be noted that most of the diffusers disperse cool air directly and individually towards the suction inlets of each of the electronic equipments, but some of the diffusers may disperse cool air also towards the sides of the electronic equipments.

Preferably, the cabinet of the present invention further includes a front door disposed at the front of the cabinet The cabinet may also include side panels, a back panel and a top panel to enclose the cabinet. In embodiments of the present invention a back door is disposed at the back of the cabinet.

The doors and/or panels are preferably made of rigid materials such as glass, wherein the rigid materials are clear, opaque or partially opaque. The doors and the panels enable fast access to the electronic equipments installed in the cabinet. By providing doors and/or panels that can be view through, monitoring of the electronic equipments installed in the cabinet is provided.

In embodiments of the present invention, one or more of the doors and/or panels are perforated to allow the air coming out of the electronic equipments to flow out of the cabinet into the room where the cabinet operates. It should be noted that the perforation of the doors and/or panels does not interfere with the operation and cooling of the cabinet.

In embodiments of the present invention, the doors and/or panels are a silent.

In embodiments of the present invention, the cabinet further includes one or more communication wiring ducts, with free access to the wiring and without interfering with the operation and cooling of the cabinet.

In embodiments of the present invention, the cabinet further includes one or more electric wiring posts, with free access to the wiring without interfering with the operation and cooling of the cabinet.

In preferred embodiments of the present invention, the front door includes an electrically controlled unlocking mechanism, wherein upon a failure to reduce the maximal temperature below a preset threshold temperature, the unlocking mechanism opens said front door.

### BRIEF DESCRIPTION OF THE DRAWINGS

The present invention will become fully understood from the detailed description given herein below and the accompanying drawings, which are given by way of illustration and example only and thus not limitative of the present invention, and wherein:
FIG. 1 is a schematic perspective view illustration of an integrated, active cooled cabinet for electronic equipment, according to embodiments of the present invention.
FIG. 2 is a front view illustration of an integrated, active cooled cabinet for electronic equipment, according to embodiments of the present invention, having a blower connected to a cool air source coming from the floor.
FIG. 3 is a cross sectional view taken along line A-A' of Figure 2.
FIG. 4 is a front view illustration of an integrated, active cooled cabinet for electronic equipment, according to embodiments of the present invention, having a blower connected to a cool air source coming from the ceiling.
FIG. 5 is a front view illustration of a multi-cabinet system, according to embodiments of the present invention.

### DETAILED DESCRIPTION OF THE INVENTION

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided ,so that this disclosure will be thorough and complete, and will fully convey the scope of the invention to those skilled in the art.

Unless otherwise defined, all technical and scientific terms used herein have the same meaning as commonly understood by one of ordinary skill in the art to which this invention belongs. The methods and examples provided herein are illustrative only and not intended to be limiting.

By way of introduction, the principal intentions of the present invention include providing an integrated active cooled cabinet/rack for electronic equipments. An aspect of the present invention is to provide a controlled cooling of the cabinet, that enables individual equipment cooling and monitoring and thereby ensure that the equipment housed in the cabinet and generating the highest level of heat is cooled down to an acceptable preset temperature.

Reference is now made to Figure 1, which a schematic perspective view illustration of an integrated, active cooled cabinet **100** for electronic equipment **50,** according to embodiments of the present invention. Cabinet **100** includes a cool air supply unit, posts **110** for channeling high pressure cool air towards racks **105,** through diffusers **130** and control unit **190.** Cabinet **100** may further include one or more communication panels **170,** electrical wiring posts **140.**

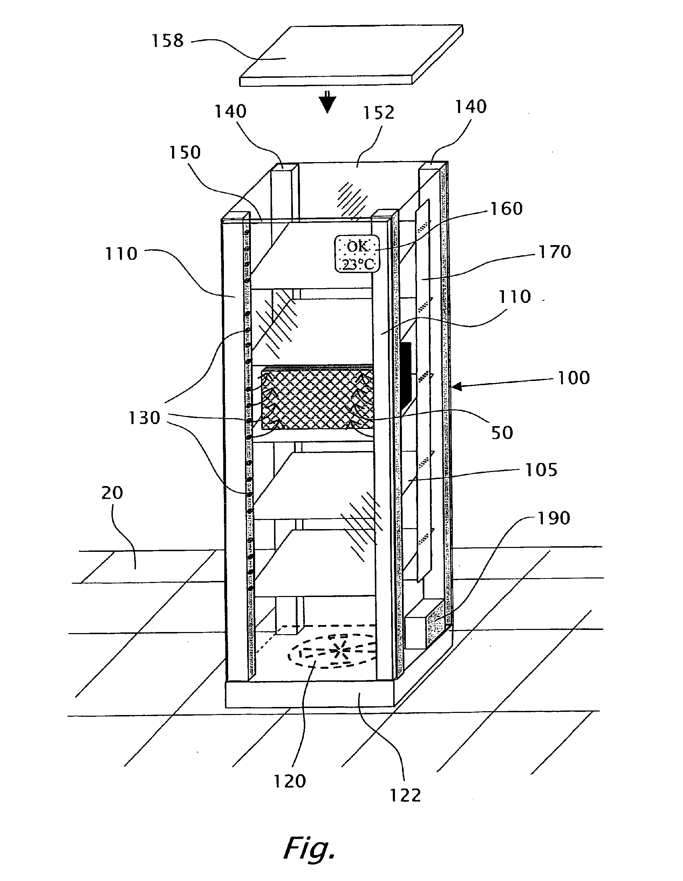

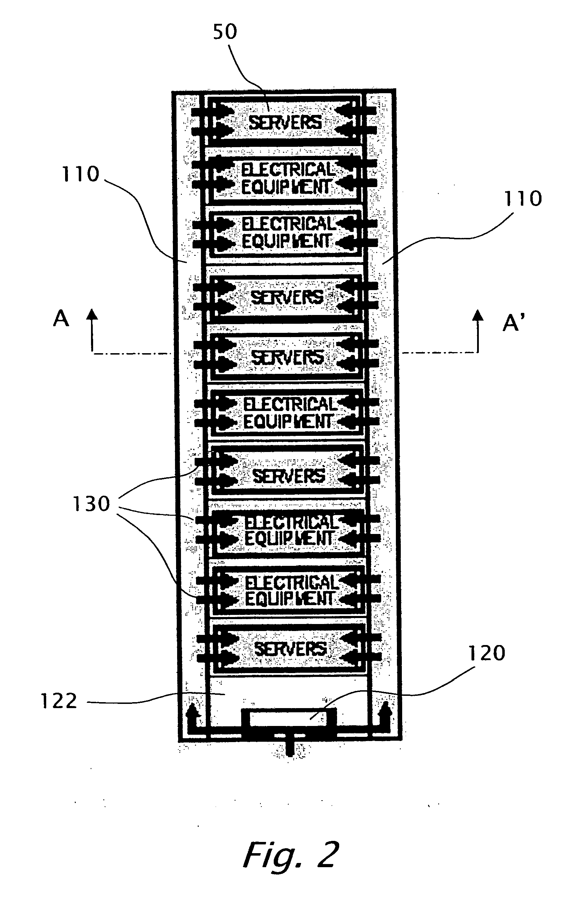

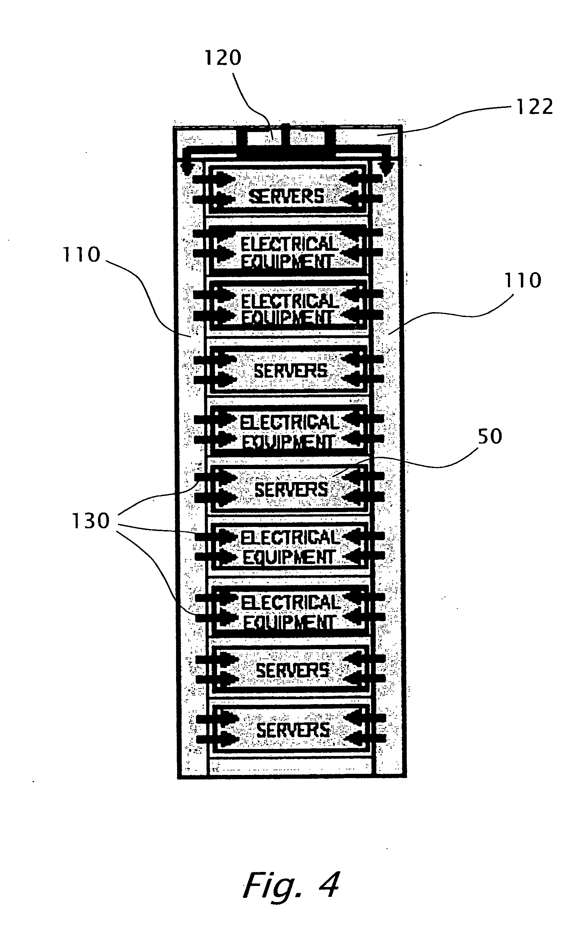

Preferably, the cool air supply unit includes an air propelling device such as blower **120** which is operatively connected to an external source of cool air such as air conditioned raised floor or air conditioned room. Reference is also made to Figure 2, which is a front view illustration of cabinet **100,** having blower **120** operatively connected to a cool air source coming from the floor, typically raised floor **20,** and to Figure 4, which is a front view illustration of cabinet **100,** according to embodiments of the present invention, having blower **120** operatively connected to a cool air source coming from the ceiling.

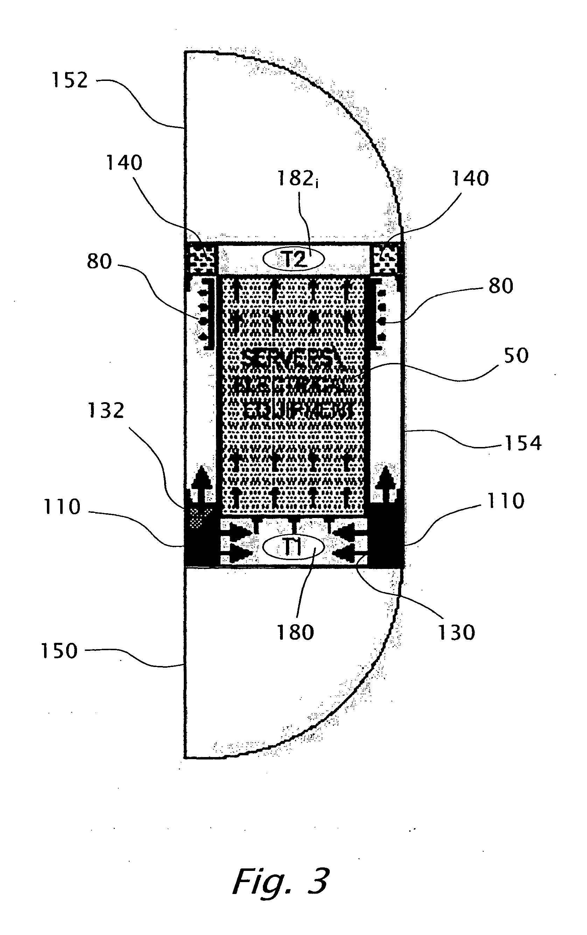

The cool air supply unit draws cool air, typically from an external source, and pumps the cool air at high, pre designed pressure, into posts **110.** Posts **110** are designed to accommodate the cooled airflow which pours out of the designated diffusers **130** directly towards the air suction inlets of each individual electronic item **50** housed inside cabinet **100.** Each individual electronic item **50** is supplied with the proper amount of cooled airflow. Reference is also made to Figure 3, which is a cross sectional view taken along line A-A' of Figure 2, wherein cabinet **100** does not include ceiling **158** or ceiling **158** is removed. Preferably, cabinet **100** further include a front door **150** a back door or panel **152** and optionally side panels **154.** Cabinet **100** may further include ceiling **158.** The doors and/or panels **(150, 152** and **154)** and/or ceiling **158** can be made of clear material such that the electronic equipment can be seen through the clear doors and/or panels **(150, 152** and **154)** and/or ceiling **158.** The doors/panels **(150, 152** and **154)** and/or ceiling **158** may be partially clear, opaque, or perforated. It should be noted that the cooling process of cabinet **100** works well, weather doors/panels **(150, 152** and **154)** and/or ceiling **158** are assembled or not.

Optionally, posts **110** also include diffusers **132** (Figure 3), which disperse cool air to the sides of electronic equipments **50.**

The dispersing of cooled air from posts **110** to each of the individual electronic items **50** is automatically regulated by control unit **190,** and directed directly towards suction inlet of each of the individual electronic equipment **50.** Control unit **190** includes temperature sensor **180** that measures the temperature (*T1*) of the incoming cool air, and multiple sensors **182** that measure the air temperature (*T2ᵢ*) coming out of each electronic equipment **50:** Control unit **190** determines temperature *T2ₘₐₓ*, being the highest measured temperature *T2ᵢ*. If *T2ₘₐₓ* is greater than a preset threshold value (*Tₜₕᵣ*), control unit **190** increases the flow of cooled air supply, for example, by increasing the rotational speed of blower **120,** until *T2ₘₐₓ ≤ Tₜₕᵣ.* As more cool air is flowing through the overheated electronic equipment **50** having T2 = Tₘₐₓ, Tₘₐₓ decreases gradually until corresponding sensor **182ᵢ** senses a temperature *T2ₘₐₓ ≤ Tₜₕᵣ.*

It should be noted that by reducing *T2ₘₐₓ* to be below *Tₜₕᵣ*, control unit **190** ensures that ALL electronic equipments **50** in cabinet **100** have a *T2ᵢ ≤ Tₜₕᵣ.*

Cabinet **100** is structured such that it allows easy frontal and/or posterior access to each of the individual electronic items **130** housed inside cabinet **100.** Furthermore, preferably, each of the individual electronic equipment **50** can also be easily viewed from the front and/or back of cabinet **100.**

Cabinet **100** preferably includes posts **140,** which are designated for electric wiring of cabinet **100,** whereas there is a complete separation between the inner space of cooling posts **110** and the inner space of wiring posts **140.** Cables, including electricity supply, may reach posts **140,** or other parts of cabinet **100,** from the floor, the ceiling or from anywhere else, whereas there is no obstruction in the operation of the cooling system of cabinet **100.** The electric wiring typically serves the electric needs of electronic equipments **50.**

Cabinet **100** preferably include one or more communication panels **170,** which are designated for communication wiring of cabinet **100,** whereas there is no obstruction in the operation of the cooling system of cabinet **100.** The communication wiring typically serves the communication wiring needs of electronic equipments **50.**

Optionally, cabinet **100** further includes display **160** which displays data related to cabinet **100.** For example, control panel **190** can display on display **160** the current *T2i* of each individual electronic equipment, *T2ₘₐₓ, T1,* the humidity inside cabinet **100,** *Tₜₕᵣ* and the heat dissipation load, for example, in KW. If *T2ᵢ ≤ Tₜₕᵣ,* display **160** displays, for example, a green OK message, and if *T2ᵢ* > *T*_{*th*r}, display **160** displays, for example, temperature *T2ₘₐₓ* in red illumination. More than one display **160** can be utilized, for example, for each rack. All controlled information and alarms such as the data displayed on display **160,** can be transmitted to an external control system.

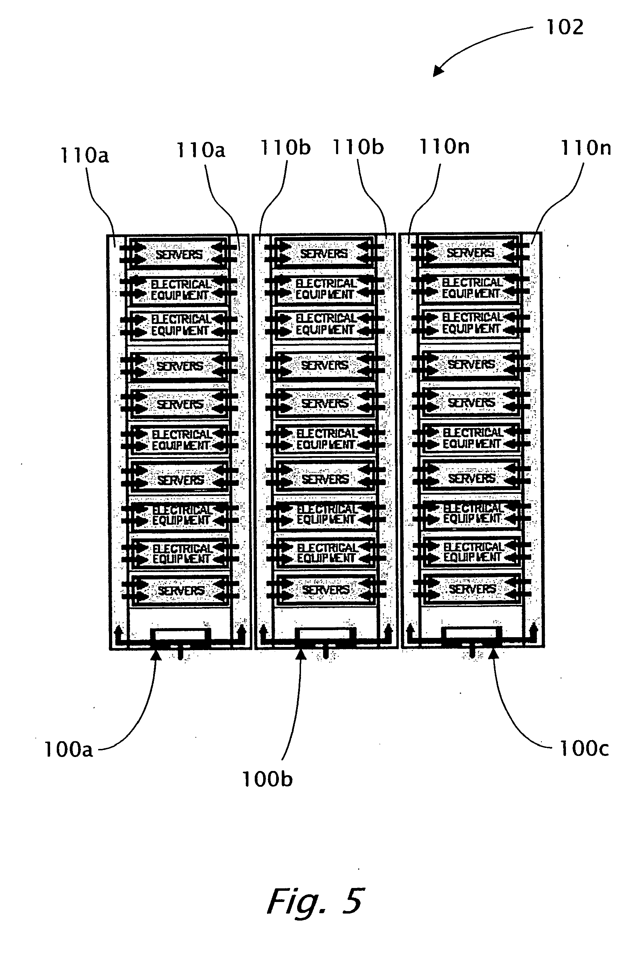

Preferably, cabinet **100** is a modular cabinet, and thereby can be connected to other cabinets **100**, side-by-side. Figure 5 illustrates an example multi-cabinet system **102,** according to embodiments of the present invention, having three cabinets **100** attached to each other, side-by-side. Each cabinet **100** is still controlled and operated individually, and thereby each electronic equipment **50** is still controlled individually.

In embodiments of the present invention, front door **150** and/or back door **152** of cabinet **100** include an electrically controlled unlocking mechanism, such as an electromagnet. Thereby, in case of a failure to reduce the current *T2ₘₐₓ* such that *T2ₘₐₓ ≤ Tₜₕᵣ,* the doors (**150** and/or **152**) open automatically. A for a preset period of time will cause control unit **190** to automatically open electrically controlled unlocking mechanism. Optionally, in case of a failure in the incoming flow of cool air can be caused by failure of the external air condition or failure of blower **120,** the doors (**150** and/or **152**) open automatically. A failure in the incoming flow of cool air can be controlled by control unit **190,** by checking the *T1* is below some threshold temperature.

In embodiments of the present invention, the air propelling device such as blower **120** includes two devices, for example two blowers **120,** such that one is a backup for the other. Typically, each blower **120** works at about 50% of the device capacity. When one blower **120** fails, at least partially, the second blower **120** provides the lost capacity of air propelling power.

In embodiments of the present invention, when a rack **105** is vacant, corresponding diffusers **130** and/or **132** are blocked from diffusing cool air.

An aspect of an active cooled cabinet of the present invention is to supply the required cooling air load, needed to dissipate the heat load of any electronic equipment **50** installed inside cabinet, directly to electronic equipment **50**, regardless of the air conditioning needs of the room housing cabinet **100**. Hence, cabinets **100** of the present invention significantly reduce the number of air conditioning units required to cool a server room and thereby significantly reduce the energy consumed for cooling computer rooms and computer centers. Cabinets **100** of the present invention automatically consumes substantially the exact air capacity needed to maintain the required operating temperature of electronic equipment **50,** typically saving 2/3 of the total room air conditioning air flow, relative to prior art system. Control unit **190** computes: Δ*T* = *T2ₘₐₓ - T1* to determine the cooling air load that is needed to maintain an appropriate *T2ₘₐₓ*. That is, if either *T2ₘₐₓ* or *T1* increase, more cooling air load is needed, and if either *T2ₘₐₓ* or *T1* decrease, less cooling air load is needed.

Although the present invention has been described with reference to the preferred embodiment and examples thereof, it will be understood that the invention is not limited to the details thereof. Various substitutions and modifications have suggested in the foregoing description, and other will occur to those of ordinary skill in the art. Therefore, all such substitutions and modifications are intended to be embraced within the scope of the invention as defined in the following claims.

## Claims

1. A cabinet (100) for housing one or more electronic equipments (50) placed on racks (105), having a front side (150), a back side (152), two sided sides (154) and a top side (158), the cabinet (100) comprising:
(a) a cool air supply unit comprising an air propelling device (120);
(b) a control unit (190) comprising:
i) at least one sensor (180,182) at the back of each one of said racks (105) for sensing the temperature (T2i) of the air coming out of said electronic equipment (50) disposed on said at least one of said racks (105); and
ii) a processing unit; and
(c) one or two hollow posts (110) disposed at the corners of said front (150), wherein each of
said hollow posts (110) comprises diffusers (130,132) for dispersing cool air,
wherein said cool air supply unit is operatively connected to an external source of cool air and said air propelling device (120) compresses cool air from said external source of cool air into said hollow posts (110), and wherein said external source of cool air is selected from the group including air conditioned raised floor (20) and a canal connected to an air conditioning unit;
wherein said compressed cool air further flows through said diffusers (130,132) for dispersing cool air directly and individually towards the suction inlet of each of said electronic equipments (50) placed on said racks (105), thereby cooling each of said electronic equipments (50);
wherein said processing unit is adapted to process said sensed temperatures (T2i) of said air coming out of said electronic equipments (50) disposed on said at least one of said racks (105), to thereby determine the maximal temperature (T2max) coming out of said electronic equipments (50);
wherein said processing unit is adapted to control said compression of the cool air supplied into said hollow posts (110) by said air propelling device (120), based on said maximal temperature (T2max);
and wherein when at least one of said front side (150), back side (152), two sided sides (154) and
top side (158) is opened, said opened side does not interfere with the operation and cooling of the cabinet (100).

2. The cabinet (100) as in claim 1 further comprising a sensor (180,182) for sensing the temperature (T1) of said cool air supplied by said cool air supply unit.

3. The cabinet (100) as in claim 1, wherein said air propelling device is a blower (120).

4. The cabinet (100) as in claim 1, wherein said diffusers (130,132) disperse said cool air towards the sides of said electronic equipments (50).

5. The cabinet (100) as in claim 1 further comprising a front door (150).

6. The cabinet (100) as in claim 6, wherein said front door (150) comprises an electrically controlled unlocking mechanism, wherein upon a failure to reduce said maximal temperature (T2max) below a preset threshold temperature (Tthr), said unlocking mechanism opens said front door (150).

7. The cabinet (100) as in claim 1 further comprising a back door or a back panel (152).

8. The cabinet (100) as in claims 8, wherein said back panel or back door (152) is perforated and wherein said perforation of said back panel or back door (152) does not interfere with the operation and cooling of the cabinet (100).

9. The cabinet (100) as in claim 1 further comprising one or more communication wiring ducts (140), with free access to the wiring without interfering with the operation and cooling of the cabinet (100).

10. The cabinet (100) as in claim 1 further comprising one or more electric wiring posts (140), with free access to the wiring without interfering with the operation and cooling of the cabinet (100).

11. A method for reducing the operational temperature of each one of the electronic equipments (50) placed on racks (105) inside a cabinet (100) according to claim 1, said method comprising the steps of:
(a) sensing the temperature (T2i) of the air coming out of said electronic equipment (50) disposed on said at least one of said racks (105);
(b) dispersing cool air directly and individually to each one of the electronic equipment (50) installed in the cabinet (100);
(c) compressing cool air from said external source of cool air into said hollow posts (110);
(d) dispersing said compressed cool air through said diffusers (130,132) towards each of said electronic equipments (50) placed on said racks (105), thereby cooling each of said electronic equipments (50); and
(e) processing said sensed temperatures (T2i) of said air coming out of each of said electronic equipments (50), to thereby determine the maximal temperature (T2max) coming out of said electronic equipments (50); and
(f) controlling said compression of the cool air supplied into said hollow posts (110) by said air propelling device (120), based on said maximal temperature (T2max).

12. The method as in claiM 12 wherein step (f) is carried out by comparing said maximum sensed temperature (T2max) to a preset threshold value (Tₜₕᵣ) so that upon detecting that said maximum sensed temperature (T2max) is greater than said preset threshold value (Tₜₕᵣ), said cool air supply unit is activated by said processor.

13. The method as in claim 12 further comprising the step:
(g) sensing the temperature (T1) of said cool air supplied by said cool air supply unit; and
(h) determining the air capacity needed to substantially maintain the required operating temperature of said electronic equipment (50).

## Patentansprüche

1. Ein Schrank (100) zur Aufnahme einer oder mehrerer elektronischer Ausrüstungen (50), die auf Gestellen (105) angebracht sind, der eine Vorderseite (150), eine Rückseite (152), zwei seitliche Seiten (154) und eine Oberseite (158) hat, wobei der Schrank (100) Folgendes umfasst:
(a) eine Zufuhreinheit für kühle Luft, die eine Luftantriebsvorrichtung (120) umfasst,
(b) eine Steuereinheit (190), die Folgendes umfasst:
(i) mindestens einen Sensor (180, 182) an der Rückseite jedes der Gestelle (105) zur Messung der Temperatur (T2i) der Luft, die aus der elektronischen Ausrüstung (50) herauskommt, die auf dem mindestens einen der Gestelle (105) angebracht ist, und
(ii) eine Verarbeitungseinheit; und
(c) einen oder zwei hohle Pfosten (110), die an den Ecken der Vorderseite (150) angeordnet sind, wobei jeder der hohlen Pfosten (110) Diffusoren (130, 132) zur Verteilung kühler Luft umfasst,
wobei die Zufuhreinheit für kühle Luft operativ mit einer externen Quelle für kühle Luft verbunden ist und die Luftantriebsvorrichtung (120) kühle Luft von der externen Quelle für kühle Luft in die hohlen Pfosten (110) komprimiert und wobei die externe Quelle für kühle Luft gewählt ist aus der Gruppe, die einen klimatisierten Doppelboden (20) und einen Kanal einschließt, der mit einer Klimatisierungseinheit verbunden ist, wobei die komprimierte kühle Luft weiter durch die Diffusoren (130, 132) zur Verteilung kühler Luft direkt und individuell zum Saugeinlass jeder der elektronischen Ausrüstungen (50) strömt, die auf die Gestelle (105) platziert sind, und dadurch jede der elektronischen Ausrüstungen (50) kühlt,
wobei die Verarbeitungseinheit ausgebildet ist, um die gemessenen Temperaturen (T2i) der Luft, die aus den elektronischen Ausrüstungen (50) herauskommt, welche auf dem mindestens einen der Gestelle (105) angebracht sind, zu verarbeiten, um so die maximale Temperatur (T2max), die aus den elektronischen Ausrüstungen (50) herauskommt, zu bestimmen,
wobei die Verarbeitungseinheit ausgebildet ist, um die Kompression der kühlen Luft, die den hohlen Pfosten (110) von der Luftantriebsvorrichtung (120) zugeführt wird, anhand der maximalen Temperatur (T2max) zu steuern, und wobei, wenn mindestens eine der Vorderseite (150), Rückseite (152), zwei seitlichen Seiten (154) und der Oberseite (158) geöffnet ist, die geöffnete Seite den Betrieb und die Kühlung des Schranks (100) nicht behindert.

2. Der Schrank (100) gemäß Anspruch 1, der weiter einen Sensor (180, 182) zur Erfassung der Temperatur (T1) der kühlen Luft, die von der Zufuhreinheit für kühle Luft zugeführt wird, umfasst.

3. Der Schrank (100) gemäß Anspruch 1, worin die Luftantriebsvorrichtung ein Gebläse (120) ist.

4. Der Schrank (100) gemäß Anspruch 1, worin die Diffusoren (130, 132) die kühle Luft zu den Seiten der elektronischen Ausrüstungen (50) hin verteilen.

5. Der Schrank (100) gemäß Anspruch 1, der weiter eine Vordertür (150) umfasst.

6. Der Schrank (100) gemäß Anspruch 6, worin die Vordertür (150) einen elektrisch gesteuerten Entriegelungsmechanismus umfasst, wobei, wenn es nicht möglich ist, die maximale Temperatur (T2max) unter eine voreingestellte Schwellenwert-Temperatur (Tthr) zu senken, der Entriegelungsmechanismus die Vordertür (150) öffnet.

7. Der Schrank (100) gemäß Anspruch 1, der weiter eine Hintertür oder eine Rückwand (152) umfasst.

8. Der Schrank (100) gemäß Anspruch 8, worin die Rückwand oder Hintertür (152) durchlöchert ist und worin die Durchlöcherung der Rückwand oder Hintertür (152) den Betrieb und die Kühlung des Schranks (100) nicht behindert.

9. Der Schrank (100) gemäß Anspruch 1, der weiter einen oder mehrere Kommunikations-Verdrahtungskanäle (140) umfasst, mit freiem Zugang zur Verdrahtung, ohne den Betrieb und die Kühlung des Schranks (100) zu behindern.

10. Der Schrank (100) gemäß Anspruch 1, der weiter einen oder mehrere elektrische Verdrahtungspfosten (140) umfasst, mit freiem Zugang zur Verdrahtung, ohne den Betrieb und die Kühlung des Schranks (100) zu behindern.

11. Ein Verfahren zur Reduzierung der Betriebstemperatur jeder der elektronischen Ausrüstungen (50), die auf Gestelle (105) in einem Schrank (100) gemäß Anspruch 1 platziert sind, wobei das Verfahren folgende Schritte umfasst:
(a) Erfassung der Temperatur (T2i) der Luft, die aus der elektronischen Ausrüstung (50) herauskommt, die auf dem mindestens einen der Gestelle (105) angeordnet ist,
(b) Verteilung kühler Luft direkt und individuell an jede der elektronischen Ausrüstungen (50), die im Schrank (100) installiert sind,
(c) Komprimieren kühler Luft von der externen Quelle für kühle Luft in die hohlen Pfosten (110),
(d) Verteilung der komprimierten kühlen Luft durch die Diffusoren (130, 132) zu jeder der elektronischen Ausrüstungen (50) hin, die auf die Gestelle (105) platziert sind, wodurch jede der elektronischen Ausrüstungen (50) gekühlt wird, und
(e) Verarbeitung der erfassten Temperaturen (T2i) der Luft, die aus jeder der elektronischen Ausrüstungen (50) herauskommt, um so die maximale Temperatur (T2max) zu bestimmen, die aus den elektronischen Ausrüstungen (50) herauskommt, und
(f) Steuerung der Kompression der kühlen Luft, die den hohlen Pfosten (110) von der Luftantriebsvorrichtung (120) zugeführt wird, basierend auf der Maximaltemperatur (T2max).

12. Das Verfahren gemäß Anspruch 11, worin Schritt (f) durchgeführt wird durch Vergleichen der maximalen erfassten Temperatur (T2max) mit einem voreingestellten Schwellenwert (Tₜₕᵣ), so dass beim Erfassen, dass die maximale erfasste Temperatur (T2max) höher ist als der voreingestellte Schwellenwert (Tₜₕᵣ), die Zufuhreinheit für kühle Luft von dem Prozessor aktiviert wird.

13. Das Verfahren gemäß Anspruch 12, das weiter folgenden Schritt umfasst:
(g) Erfassung der Temperatur (T1) der kühlen Luft, die von der Zufuhreinheit für kühle Luft zugeführt wird, und
(h) Bestimmung der Luftkapazität, die benötigt wird, um die erforderliche Betriebstemperatur der elektronischen Ausrüstung (50) im Wesentlichen aufrechtzuerhalten.

## Revendications

1. Armoire (100) de logement d'un ou plusieurs équipements électroniques (50) positionnés sur des supports (105), ayant un côté frontal (150), un côté postérieur (152), deux côtés latérales (154) et un côté supérieur (158), l'armoire (100) comprenant:
(a) une unité d'alimentation d'air froid comprenant un dispositif de propulsion d'air (120) ;
(b) une unité de contrôle (190) comprenant:
i) au moins un capteur (180, 182) derrière chacun desdits supports (105) pour détecter la température (T2i) de l'air sortant dudit équipement électronique (50) disposé sur au moins un desdits supports ((105) ; et
(ii) une unité d'élaboration ; et
(c) un ou deux montants creux (110) disposés aux coins dudit front (150), dans lesquels chacun lesdits montants creux (110) comprend des diffuseurs (130, 132) pour disperser de l'air froid,
dans laquelle ladite unité d'alimentation d'air froid est activement liée à une source extérieure d'air froid et ledit dispositif de propulsion d'air (120) comprime de l'air froid de ladite source extérieure d'air froid dans lesdits montants (110), et dans laquelle ladite source extérieure d'air froid est sélectionnée parmi le groupe incluant un sol élevé d'air conditionné (20) et un canal lié à une unité d'air conditionné ;
dans laquelle ledit air froid comprimé coule en outre à travers lesdits diffuseurs (130, 132) pour disperser de l'air froid directement et individuellement vers l'entrée d'aspiration de chacun desdits équipements électroniques (50) positionnés sur lesdits supports (105), ainsi refroidissant chacun desdits équipements électroniques (50) ;
dans laquelle ladite unité d'élaboration est apte à élaborer lesdites températures détectées (T2i) dudit air sortant desdits équipements électroniques (50) disposés sur ledit au moins l'un desdits supports (105), pour déterminer ainsi la température maximale (T2max) issue desdits équipements électroniques (50) ;
dans laquelle ladite unité d'élaboration est apte à contrôler ladite compression d'air froid alimenté dans lesdits montants creux (110) par ledit dispositif de propulsion d'air (120), sur la base de ladite température maximale T2max) ;
et dans laquelle au moins l'un desdits côté frontal (150), côté postérieur (152), deux côtés latérales (154) et côté supérieur (158) est ouvert, ledit côté ouvert n'interférant pas avec l'alimentation et le refroidissement de l'armoire (100).

2. Armoire (100) selon la revendication 1, comprenant en outre un capteur (180, 182) pour détecter la température (T1) dudit air froid alimenté par ladite unité d'alimentation d'air froid.

3. Armoire (100) selon la revendication 1, dans laquelle ledit dispositif de propulsion d'air est une soufflante (120).

4. Armoire (100) selon la revendication 1, dans laquelle lesdits diffuseurs (130, 132) dispersent ledit air froid vers les côtés desdits équipements électroniques (50).

5. Armoire (100) selon la revendication 1, comprenant en outre une porte frontale (150).

6. Armoire (100) selon la revendication 6, dans laquelle la porte frontale (150) comprend un mécanisme de déverrouillage commandé électriquement, dans lequel au cas où une réduction de ladite température maximale (T2max) au-dessous d'une température de seuil prédéterminée (Tₜₕᵣ) abouait à un échec, ledit mécanisme de déverrouillage ouvre ladite porte frontale (150).

7. Armoire (100) selon la revendication 1, comprenant en outre une porte postérieure ou un panneau postérieur (152).

8. Armoire (100) selon la revendication 8, dans laquelle ledit panneau postérieur ou porte postérieure (152) est ajourée et dans laquelle ledit ajour dudit panneau postérieur ou porte postérieure (152) n'interfère pas avec l'alimentation et le refroidissement de l'armoire (100).

9. Armoire (100) selon la revendication 1, comprenant en outre un ou plusieurs conduits de lignes de communication (140), avec un accès libre aux lignes sans interférer avec l'alimentation et le refroidissement de l'armoire (100).

10. Armoire (100) selon la revendication 1 comprenant en outre un ou plusieurs montants de lignes électriques (140), avec un accès libre aux lignes sans interférer avec l'alimentation et le refroidissement de l'armoire (100).

11. Procédé de réduction de la température d'alimentation de chacun des équipements électroniques (50) disposés sur des supports (105) au sein d'une armoire (100) selon la revendication 1, ledit procédé comprenant les étapes de :
(a) détection de la température (T2i) de l'air sortant dudit équipement électronique (50) disposé sur ledit au moins l'un desdits supports (105) ;
(b) dispersion de l'air froid directement et individuellement à chaque équipement électronique (50) installé dans l'armoire (100) ;
(c) compression de l'air froid de ladite source extérieure d'air froid dans lesdits montants creux (110) ;
(d) dispersion dudit air froid comprimé à travers lesdits diffuseurs (130, 132) vers chacun desdits équipements électroniques (50) placés sur lesdits supports (105), de sorte à refroidir chacun desdits équipements électroniques (50) ; et
(e) élaboration desdites températures détectées (T2i) dudit air sortant de chacun desdits équipements électroniques (50), de sorte à déterminer la température maximale (T2max) sortant desdits équipements électroniques (50) ; et
(f) contrôle de ladite compression de l'air froid alimenté au sein desdits montants creux (110) par ledit dispositif de propulsion d'air (120), sur la base de ladite température maximale (T2max).

12. Procédé selon la revendication 11, dans lequel l'étape (f) est performée en comparant ladite température détectée maximale (T2max) à une valeur de seuil prédéfinie (Tₜₕᵣ) de sorte que lorsqu'il est détecté que ladite température détectée maximale (T2max) est supérieure à ladite valeur de seuil prédéfinie (Tₜₕᵣ), ladite unité d'alimentation d'air froid est activée par ledit processeur.

13. Procédé selon la revendication 12, comprenant en outre l'étape de :
(g) détection de la température (T1) dudit air froid alimenté par ladite unité d'alimentation d'air froid ; et
(h) détermination de la portée d'air nécessaire afin de maintenir essentiellement la température d'alimentation demandée dudit équipement électronique (50).
